# EUROPEAN PATENT APPLICATION

(11) **EP 0 725 446 A1**
(43) Date of publication of application: **07.08.1996**
(21) Application number: 96101258.0
(22) Date of filing: 30.01.1996
(51) Int. Cl.: H01L 29/739

(54) **Insulated gate bipolar semiconductor device and method therefor**

(30) Priority: 02.02.1995 US 382710
(71) Applicant: MOTOROLA, INC., Schaumburg, IL 60196 (US)
(72) Inventor: Mamileti, Lakshmikant, Drive, Phoenix, Arizona 85044 (US)
(74) Representative: Spaulding, Sarah Jane

(57) **Abstract**

An insulated gate semiconductor device (10) is formed having a buffer layer (13) having a graded dopant profile. The graded dopant profile improves the reverse blocking voltage of the device (10) while maintaining the switching speed.

## Description

### Background of the Invention

This invention relates, in general, to insulated gate semiconductor devices, and more particularly to an insulated gate semiconductor device having high reverse blocking.

Insulated gate semiconductor devices, also known as insulated gate bipolar transistors (IGBT), are well known. The basic IGBT suffers from a latch-up condition and slow switching speed. These devices are slow switching because minority carriers in the drift region need to decay and this causes a tail current.

Both of these conditions were alleviated by the addition of a highly doped N layer positioned between the anode and the epitaxial layer of the IGBT. This highly doped N layer is also called a buffer layer.

One of the disadvantages of adding the highly doped buffer layer to the IGBT device is that the reverse blocking voltage is marginal. Typical devices have a reverse blocking voltage of 24 volts for a switching speed of 1-2 microseconds. There are applications where it would be desirable to have an IGBT with a higher reverse blocking voltage at the same switching speed.

### Brief Description of the Drawings

FIG. 1 illustrates an enlarged cross-sectional view of a portion of an insulated gate semiconductor device using the present invention;
FIG. 2 illustrates a graph of the doping profile in one embodiment of the present invention;
FIG. 3 illustrates a graph of the doping profile in another embodiment of the present invention; and
FIG. 4 illustrates a graph of the doping profile of the prior art.

### Detailed Description of the Drawings

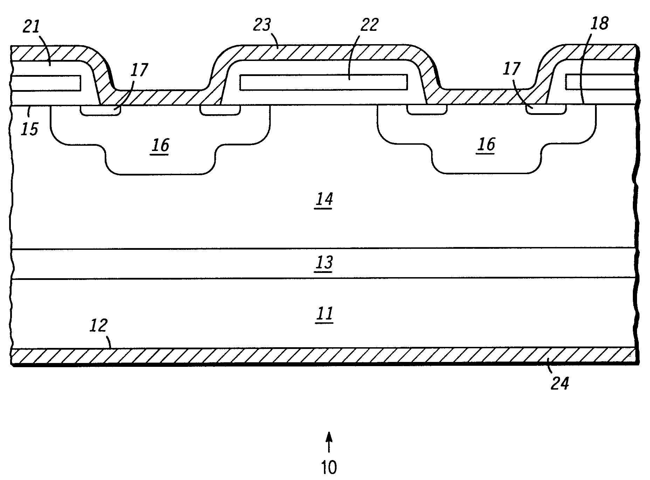

FIG. 1 illustrates an enlarged cross sectional view of a portion of an insulated gate semiconductor device 10. Insulated gate semiconductor device 10 is comprised of a semiconductor substrate 11 of a first conductivity type. In this particular embodiment, substrate 11 is comprised of a P type semiconductor material. A graded buffer layer 13 is disposed over substrate 11. Graded buffer layer 13 is of a second conductivity type and in this embodiment is comprised of an N type semiconductor material. A semiconductor layer 14, typically called the drift region, is disposed over grated buffer layer 13. Semiconductor layer 14 is of the second conductivity type and is more lightly doped than graded buffer layer 13.

A doped region or base region 16 is formed in a portion of semiconductor layer 14 extending from the top surface into a portion of semiconductor layer 14. Base regions 16 are laterally spaced apart from one another and extend from the top surface into semiconductor layer 14. Base region 16 is of a first conductivity type and is preferably formed by ion implantation. Note that a plurality of base regions 16 may be formed in semiconductor layer 14, of which only two are shown for illustrative convenience. Also base region 16 may be a single region having a portion of semiconductor layer 14 between base region 16 at the top surface.

A doped region or emitter region 17 is formed in base region 16 extending from the top surface of semiconductor layer 14. Emitter region 17 has a central opening forming a donut shape, which in the cross sectional view illustrated appears as two regions of the second conductivity type. Emitter region 17 is of the first conductivity type. A channel region 18 is formed between emitter region 17 and the periphery of base region 16.

An insulating layer 21 serves as a gate oxide between semiconductor layer 14 and a gate 22. Insulating layer 21 also serves to insulate gate 22 from an emitter electrode 23 which is comprised of a metal layer. Emitter electrode 23 forms an electrical contact to emitter region 17 and base region 16 or shorts emitter region 17 to base region 16. Metallization layer 24 is formed on and makes electrical contact to the bottom surface of substrate 11 and serves as collector metallization.

Insulated gate semiconductor device 10 is enabled when a voltage, which is sufficient to cause an inversion in channel 18, is applied to gate 22. When the inversion occurs, electrons will flow from emitter region 17 through channel region 18 and semiconductor layer 14, down to collector metallization 24.

In a preferred embodiment, semiconductor layer 14 has a thickness ranging between approximately 100 to 300 microns and is lightly doped with a dopant or impurity material of the N conductivity type. In one example, semiconductor layer 14 has an impurity concentration of approximately 1x10¹⁴ atoms per cubic centimeter. Semiconductor layer 14 is preferably a monocrystalline semiconductor material having a substantially uniform impurity concentration of N conductivity type that may be formed using non-epitaxial growth techniques such as a Czochralski process or a float zone process, or using epitaxial growth techniques.

Base regions 16 preferably have a concentration of P type impurity material ranging between approximately 4.5 x 10¹³ atoms per cubic centimeter to 5.5 x 10¹³ atoms per cubic centimeter. Base regions 16 may have, for example, a maximum width of approximately 20 microns and a maximum depth of approximately 4 microns.

Emitter regions 17 have a concentration ranging between approximately 1 x 10¹⁶ atoms per cubic centimeter to 5 x 10¹⁶ atoms per cubic centimeter. Emitter region 17 may have a width ranging between approximately 1 to 3 micrometers and a maximum depth of approximately 1.5 micrometers.

Preferably, emitter electrode 23 is comprised of aluminum. Substrate 11 is preferably comprised of a semiconductor material having a resistivity of approximately 0.01 to 0.03 ohm-cm. Metallization 24 is also preferably comprised of metal layers such as titanium-nickel-silver.

In accordance with the present invention, graded buffer layer 13 is preferably comprised of a semiconductor material having a resistivity ranging between approximately .03 to 30 ohm-cm. The thickness of graded buffer layer 13 is preferably in the range of 2 to 100 microns. As used herein, the term graded means that the doping profile of graded buffer layer 13 is not substantially uniform throughout the thickness of graded buffer layer 13. Graded buffer layer 13 may have a linear, graded profile as shown in FIG. 2. Graded buffer layer 13 may also have a stepped, graded profile as shown in FIG. 3. FIG. 3 illustrates an embodiment where the number of steps equals 2, however, one or more steps may be formed. A stepped, graded, dopant profile may be more controllable to manufacture than a linear, graded profile. Note that the linear graded profile represents the case where the number of steps equals infinity.

A dopant profile of the prior art is illustrated in the graph of FIG. 4. In the past, the transition width from peak doping of a buffer layer to a substrate was approximately 1 micron, thereafter the doping concentration was substantially uniform. Although a transition in the doping from the substrate and the buffer layer must be present, the doping concentration of the buffer layer throughout the thickness is substantially uniform and therefore not defined as having a graded profile as in the present invention where the doping is not substantially uniform throughout the thickness of buffer layer 13.

More preferably, the transition from the peak doping of graded buffer layer 13 to substrate 11 in the present invention occurs at a width of approximately 7-11 microns or greater than or equal to 7 microns from the substrate. Preferably, buffer layer 13 has a peak resistivity of greater than or equal to 0.09 ohm-cm. The presence of this doping gradient improves the reverse blocking voltage capability. Most preferably, the transition width is greater than or equal to approximately 9 microns in order to further improve the reverse blocking voltage.

The peak N concentration of graded buffer layer 13 still determines the switching speed of the device by controlling the injection efficiency of substrate 11. Thus, the switching speed is comparable to devices having fast switching speeds of 1.5 to 2.0 microseconds.

In summary, providing a buffer layer 13 which has a graded dopant profile provides the improved reverse blocking voltage. In the past devices exhibit a reverse blocking voltage of approximately 25 volts. The devices of the present invention exhibit a reverse blocking voltage of 40 volts and above.

An advantage of the present invention is that graded buffer layer 13 can be formed during epitaxial growth, thus, no additional steps or layers are added to the device. Applications where high reverse blocking voltages are advantageous include automotive ignition systems.

As can be seen, an insulated gate semiconductor device has been provided having an increased reverse blocking voltage and having fast switching speed. The improvement is result of providing a buffer layer having a graded dopant profile rather than a uniform concentration throughout.

## Claims

1. An insulated gate semiconductor device, comprising:
a semiconductor layer (11) of a first conductivity type;
a buffer layer (13) of a second conductivity type having a graded dopant profile disposed over the semiconductor layer (11) of the first conductivity type;
a semiconductor layer (14) of the second conductivity type disposed over the buffer layer (13);
a doped region (16) of the first conductivity type disposed in the semiconductor layer (14) of the second conductivity type; and
a doped region (17) of the second conductivity type disposed in a portion of the doped region (16) of the first conductivity type.

2. The insulated gate semiconductor device of claim 1 wherein the graded dopant profile of the buffer layer (13) is linear.

3. The insulated gate semiconductor device of claim 1 wherein the graded dopant profile of the buffer layer (13) is stepped.

4. The insulated gate semiconductor device of claim 1 wherein the graded dopant profile of the buffer layer (13) has a peak doping at greater than or equal to 7 microns from the semiconductor layer (11) of the first conductivity type.

5. The insulated gate semiconductor device of claim 1 wherein the graded dopant profile of the buffer layer (13) has a peak doping at greater than or equal to 9 microns from the semiconductor layer (11) of the first conductivity type.

6. The insulated gate semiconductor device of claim 1 wherein the graded dopant profile of the buffer layer (13) has a resistivity of 0.03 to 30 ohm-cm.

7. A method of forming an insulated gate semiconductor device, comprising the steps of:
providing a semiconductor layer (11) of a first conductivity type;
forming a buffer layer (13) of a second conductivity type having a graded dopant profile over the semiconductor layer (11) of the first conductivity type;
forming a semiconductor layer (14) of the second conductivity type over the buffer layer (13);
forming a doped region (16) of the first conductivity type in the semiconductor layer (14) of the second conductivity type; and
forming a doped region (17) of the second conductivity type in a portion of the doped region (16) of the first conductivity type.

8. The method of claim 7 wherein the step of forming the buffer layer (13) comprises the graded dopant profile of the buffer layer (13) having a linear profile.

9. The method of claim 7 wherein the step of forming the buffer layer (13) comprises the graded dopant profile of the buffer layer (13) having a stepped profile.

10. The method of claim 7 wherein the step of forming the buffer layer (13) comprises the graded dopant profile of the buffer layer (13) having a peak doping at greater than or equal to 7 microns from the semiconductor layer (11) of the first conductivity type.
